Europäisches Patentamt

European Patent Office

Office européen des brevets

(19)

(11) Publication number: **0 200 689**
**A2**

(12) # EUROPEAN PATENT APPLICATION

(21) Application number: **86830099.7**

(22) Date of filing: **29.04.86**

(51) Int. Cl.⁴: **H 05 K 13/02**
**H 05 K 13/04**

(30) Priority: **29.04.85 IT 939885**

(43) Date of publication of application:
**05.11.86 Bulletin 86/45**

(84) Designated Contracting States:
**AT BE CH DE FR GB LI LU NL SE**

(71) Applicant: **Metalmeccanica Gori & Zucchi M.G.Z. S.p.A.**
**Zona Industriale San Zeno**
**I-52100 Arezzo(IT)**

(72) Inventor: **Bazzo, Ezio**
**Località Capanne 30**
**Rigutino I-52100 Arezzo(IT)**

(74) Representative: **Mannucci, Gianfranco, Dott.-Ing.**
**Ufficio Tecnico Ing. A. Mannucci Via della Scala 4**
**I-50123 Firenze(IT)**

(54) Apparatus for feeding and withdrawing electronic radial components and for other uses.

(57) The electron components (C) are applied through their appendices (R) sideways to a punched tape (N) or the like. The apparatus includes: an equipment or carrier (7, 70, 5) intended to be moved angularly step-by-step, with a pin wheel (5) able to engage the punched tape (N) in order to bring a component (C) to a withdrawal position (CT) upon each step; a kinematic chain for driving said carrier, comprising a ratchet (68), articulated members and sliding members and a driving member operated by the withdrawal tool (44) upon its movement to the withdrawal position; and a cutter (22), capable of shearing the appendices (R) of the component (C) being in the withdrawal position (CT), just before the withdrawal.

Fig. 2

## DESCRIPTION

The object of this invention is an apparatus for feeding and withdrawing radial electronic components applied through their appendices sideways to a punched tape or the like or for handling other equivalent pieces.

Substantially, the apparatus comprises:

- an equipment, that is a carrier, intended to be moved angularly step-by-step, with a peg or pin wheel able to engage the punched tape in order to bring a component to a withdrawal position upon each step;

- a kinematic chain for driving said carrier, comprising a ratchet, articulated members and sliding members and a driving member operated by the withdrawal tool upon its movement towards the withdrawal position;

- and a cutter, capable of shearing the appendices of the component in the withdrawal position just before the withdrawal.

The cutter is driven by its own driving cylinder-piston system and cooperates with a discoidal counter-cutter carried by said carrier. In order to handle components - each having two parallel appendices to be sheared, - the cutter has in its active profile two centering notches having sharp edges. The pin wheel can be registered in axial position on the angularly step-by-step

-1-

advancing carrier for the adjustment of the point where the appendices are to be sheared; said adjustment can be performed by pulling and pushing screws.

Advantageously, said kinematic chain for the operation of the ratchet, cooperates with an adjustable stop and comprises two members elastically coupled with each other and able to allow extra runs to be performed by the kinematic chain which is up-stream of said two members.

The withdrawal tool may be a clamp formed by two jaws being tightened by springs up to adjustable stops and able to be opened wide apart by a wedge member which is also of use to push the components with their appendices into the mounting holes of a printed circuit card or other.

The invention will be better understood by reading the following description and the attached drawing, which shows a practical, non limitative exemplification of the same invention. In the drawing:

Figs.1 and 2 show a side view and a plan view of the apparatus;

Figs.3 and 4 show sections according to III-III of Fig.2 and IV-IV of Fig.1;

Fig.5 is a view according to V-V of Fig.1; and

Figs.6, 7 and 8 show a clamp in a partial axial section, a view according to VII-VII and a local section according to VIII-VIII of Fig.6.

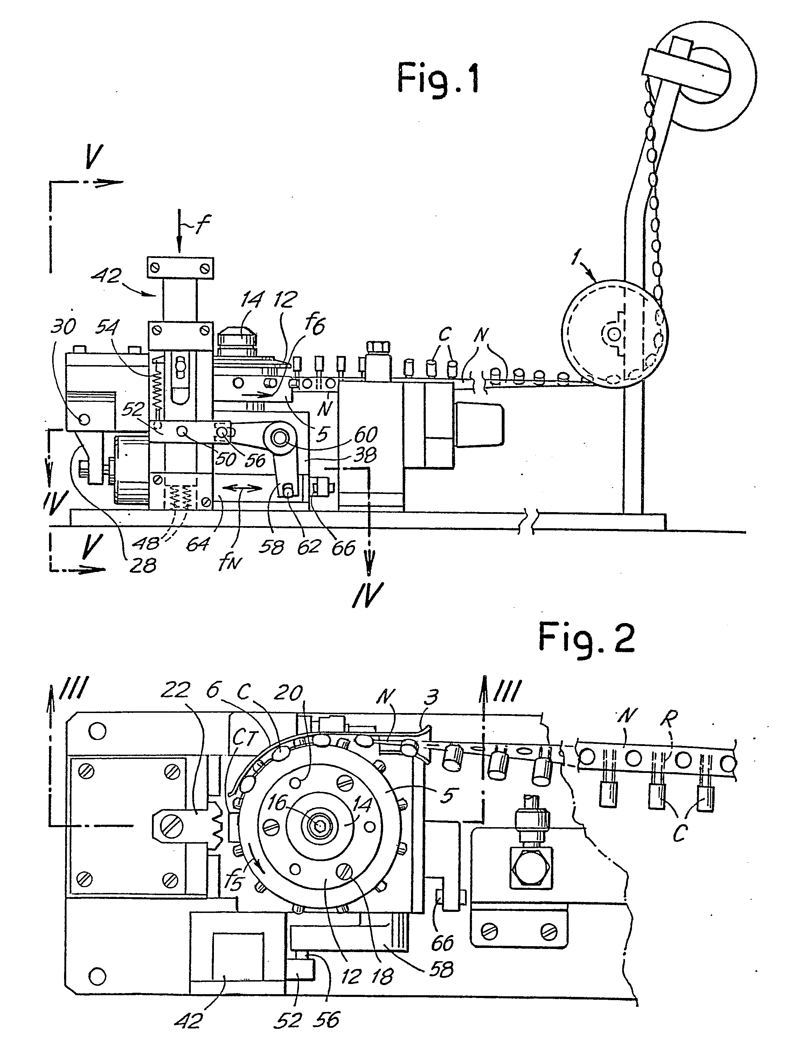

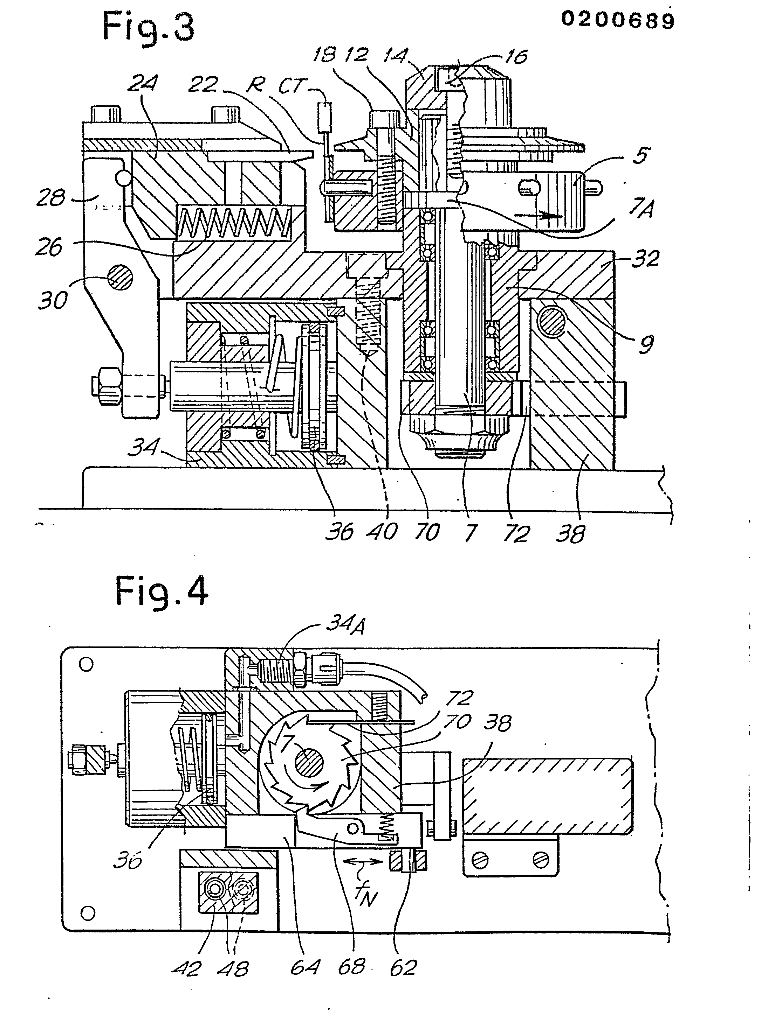

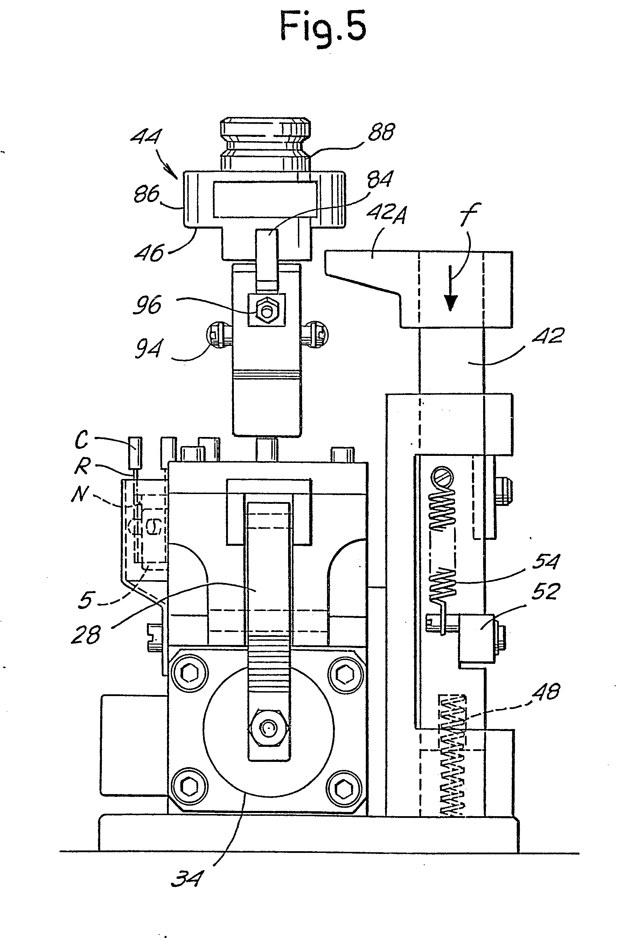

According to what is illustrated in the attached drawing (Figs.1 to 5), numeral 1 indicates a feeding unit of a tape N which engages subsequent components C through the metal appendices R making up the rheophores. From the feed zone 1, the tape N is rotated through 90° to be introduced into a mouthpiece 3 with the components C being vertically orientated upwards. The tape N has a number of holes through which it engages the pins of a dragging pin wheel 5, being guided between said wheel and a bank 6. The wheel 5 is mounted in such a way to be axially adjustable on a shaft 7 which is vertically orientated and moved with an intermittent, step-by-step motion. In particular, this shaft is mounted on a bush 9 and above the bush has a flange 7A and above the latter a disk 12 which constitutes a countercutter for cutting the appendices R of the theophores. A stop 14, engaged by an axial screw 16 on the shaft 7, locks the disk 12 into an axial position against the flange 7A of said shaft. Screws 18, disposed on the disk 12 to be parallel to the axis of the shaft 7 are intended to axially adjust the position of the pin-wheel 5 and in this way to adjust the components C position relative to the cut plane defined by the countercutter 12. For the positioning of the pin-wheel 5 - in addition to the screws 18 - dowels 20 are provided against which the pin wheel is laid down being urged by the screws 18.

The blade 22 of a cutter, which blade - as shown in the drawing - is shaped with two notches capable of centering the appendices R before cutting the latter appendices, cooperates with the countercutter 12 when same blade 22 is approached to the edge of the countercutter 12. The blade 22 is mounted on a slide 24 which is urged, in order to be moved away from the disk 12, by a spring 26 and is pushed in the opposite direction by a rocker lever 28 articulated at 30 to a block 32 which also makes up the reaction shoulder of spring 26 and the seat for bush 9. To drive the rocker lever 28, a cylinder-piston system 34, 36 is provided, whose cylinder 34 is solid with a base block 38 and whose piston 36 acts upon the rocker lever 28. The block 32 can be engaged to the base block 38 through screws 40 which become accessible after the dismounting of pieces 5, 12 and 14, after the removal of screw 16.

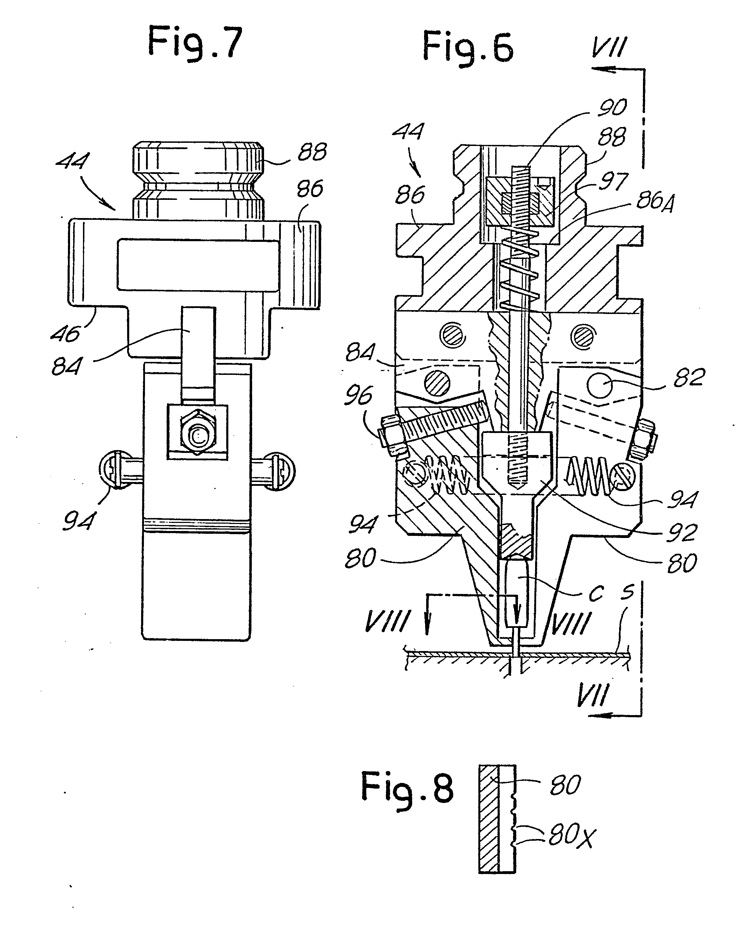

The intermittent advancement motion of the pin wheel 5 and, hence, of the shaft 7 is operated directly by the action according to arrow f on a vertical slide 42 which is made to slide with reciprocating motion according to arrow f by the same clamp tool which is provided for the withdrawal of the component C from the cut position CT. An example of a tool of this type is that indicated by 44 and best illustrated in Figs.6 to 8. The tool 44 which is

- 4 -

carried by the arm of a robot or other, is provided with surfaces 46, one of which is able to act upon the head 42A of the slide 42 to lower it according to arrow f. The slide 42 is urged by springs 48 in the opposite direction of arrow f. The slide 42 engages at 50 an oscillating member 52 which is urged by a tension spring 54 (hooked on the slide 42) against two opposite stops formed by the same slide, and is able to yield angularly (against the action of spring 54) in counterclockwise direction when watching Fig.1. The member 52 is engaged through a peg 56 with an end fork of a right-angle lever 58 rocking around a pivot 60 on the block 38. The right--angle lever 58 drives - by means of the other fork end - a peg 62 making part of a slide 64. This slide 64 can slide according to the double arrow fN up to an adjustable stop 66 carried by an appendix of block 38. The slide 64 carries an elastic ratchet 68 which is able to operate on a toothed wheel 70 mounted on the shaft 7. The reciprocating motion of slide 64 causes an intermittent angular movement of shaft 7 through the ratchet 68 and the toothed wheel 70. The back movement of the wheel 70 is hindered by an elastic plate or lamina 72 which is fitted into the block 38 and acts on the teeth of the toothed wheel 70. The reciprocating motion of the slide

64 is operated by the lowering and the lifting of the slide

- 5 -

42 through the right-angle lever 58. After the slide 64 has completed its run up to the stop 66, an excess of the lowering run of the slide 42, according to the arrow f, is allowed by the yielding of the spring 54 and the counterclockwise angular displacement (when watching Fig.1) of the member 52, after the stopping of the right-angle lever 58; this displacement is recovered through the first part of the new lift run of slide 42 by the action of springs 48; the continuation of this lift movement causes the idle run of the slide 64 and the elastic ratchet 68.

The cutter drive is achieved in time after the advancement of the shaft 7 and, hence, of the pin wheel 5, in the above described manner. The cutter drive may be operated by feeding through the connection 34 a control fluid to the cylinder-piston system 34, 36.

Figs.6 to 8 show a clamp tool which has to pick up the component C being in the position CT and to transfer it to an application position for example onto an electronic circuit card. Letter S indicates the card having holes into which the appendices R of the rheophores or the like must be inserted. The component C is picked up at the position C by two symmetrical jaws 80 which are articulated at 82 to a body 84 diametrically developed and carried by a block 86 forming the already mentioned surfaces 46 which are able to act on the slide 42. The block 86 is provided with a shank 88 for engaging the end head of an arm of a robot or other, either directly or through a sensor head. The body 86 and the shank 88 are crossed by a manoeuvre stem 90 projecting below the body 84 to carry a wedge 92. This wedge - by means of its side profiles - is able to act upon the two correspondingly shaped jaws 80 to make them open apart against the action of springs 94 which tend to tighten the active ends of the two jaws one against the other. The closure position of the jaws may be established by adjustable screw pawls 96 carried by the jaws 80 and able to rest on a central extension of the body 84. The span angle of the jaws 80 is determined by the shoulder 86A formed on the block 86 at the side of shank 88; against this shoulder 86A, a ring nut 97 - being previously registered in position on the stem 90 for the desired span - comes to rest. The stem 90 operates - by a first part of its run - the insertion of the appendices R into the holes of card S and then - by a second run part - the opening of the jaws 80 and the continuation of the insertion. The wedge 92 which can be driven by the stem 90, has, therefore, the function of opening wide apart the jaws and still the further function of pushing the component C into the holes of card S, while keeping it

- 7 -

guided even after the opening apart of jaws 80; this keeping in guide of the component C is ensured by an end shaping of wedge 92 and the guide function is provided by the appendices R after their insertion into the holes of card S; the jaws 80 have, at their ends, indentations 80X which are capable of ensuring the positioning of the appendices R received therein because of the clamping action of jaws 80 onto the component being in the production position CT, to which position such component is transferred by the pin wheel 5 and centered by the notches of the cutter 22.

The drawing shows only an exemplification given only as a practical demonstration of the invention which may vary in the forms and dispositions. The possible presence of reference numbers in the appended claims has the purpose of easing the reading of the claims, reference being made to the description and drawing, and does not have, therefore, the object of putting limitations to the scope of the protection pointed out by the claims.

C L A I M S

1. An apparatus for feeding and withdrawing electronic components or other, which are applied through their appendices (R) sideways to a punched tape or the like, characterized in that it comprises: a carrier (7, 70, 5) intended to be moved angularly step-by-step, with a pin wheel (5) able to engage the punched tape in order to carry, upon each step, a component (C) to the withdrawing position (CT); a kinematic chain for driving said carrier, including a ratchet (68), articulated members and sliding members and a driving member operated by the withdrawal tool (44) upon its displacement towards the withdrawal position; and a cutter (22), capable of shearing the appendices (R) of the component (C) in the withdrawal position (CT) just before the withdrawal.

2. Apparatus according to the preceding claim, characterized in that the cutter (22) is driven by its own driving cylinder-piston system (34, 36) and cooperates with a discoid countercutter (12) carried by said carrier.

3. Apparatus according to the preceding claims, for components (C) each having two appendices (R) to be sheared, characterized in that the cutter (22) has in its active profile two sharp-edged centering notches.

4. Apparatus according to the preceding claims, characterized in that the pin wheel (5) can be adjusted in axial position on the angularly step-by-step advancing carrier for the adjustment of the point where the appendices are to be sheared; said adjustment being possibly operated by pulling screws and pushing screws.

5. Apparatus according to the preceding claims, characterized in that the kinematic chain for the ratchet operation cooperates with an adjustable stop (66), and comprises two members (42, 52) elastically coupled between them (54) and allowing extra runs to be performed by the kinematic chain which is up-stream of said two members.

6. Apparatus according to the preceding claims, characterized in that the withdrawal tool (44) is a clamp having two jaws (80) tightened by springs (94) up to adjustable stops, and apt to be opened apart by a wedge member (92) which is also intended to push the components with their appendices into mounting holes of a printed circuit card or other.

7. Apparatus for feeding and withdrawing electronic radial components and for other uses; all as above described and represented for exemplification in the attached drawing.

14

0200689

Fig.1

Fig.2

0200689

## Fig.3

## Fig.4

0200689

# Fig.5

**Fig.7**

44
88
86
46
84
94

**Fig.6**

44
86
90
88
97
86A
84
82
96
94
94
92
80
80
C
S
VIII
VIII
VII
VII

**Fig.8**

80
80X